# EUROPEAN PATENT APPLICATION

(11) **EP 4 571 844 A1**
(43) Date of publication of application: **18.06.2025**
(21) Application number: 23852696.6
(22) Date of filing: 02.06.2023
(51) Int. Cl.: H01L 29/786, H01L 29/66, H01L 29/49, H01L 21/02

(54) **SEMICONDUCTOR CONTAINING AMORPHOUS TELLURIUM OXIDE, THIN FILM TRANSISTOR INCLUDING SAME, AND FABRICATION METHOD THEREFOR**

(30) Priority: 11.08.2022 KR 20220100434; 26.05.2023 KR 20230068542
(71) Applicant: POSTECH Research and Business Development Foundation, Pohang-si, Gyeongsangbuk-do 37673 (KR)
(72) Inventor: NOH, Yong-Young, Pohang-si Gyeongsangbuk-do 37673 (KR); LIU, Ao, Pohang-si Gyeongsangbuk-do 37673 (KR)
(74) Representative: Stolmár & Partner Patentanwälte PartG mbB
(86) International application number: PCT/KR2023/007626
(87) International publication number: WO 2024/034807

(57) **Abstract**

Disclosed are a semiconductor comprising amorphous tellurium oxide, thin film transistor and method of fabricating same. In detail, a semiconductor comprising a chalcogen atom comprising at least one selected from the group consisting of a sulfur atom (S) and a selenium atom (Se); and tellurium composite comprising a tellurium (Te) atom and tellurium oxide. A thin film transistor (TFT) fabricated based on the TeOₓ channel layer according to the present disclosure exhibits excellent output/transfer characteristics and superior electrical performance with high hole field-effect mobility and a high on/off current ratio of ~10⁷.

## Description

### Technical Field

The present disclosure relates to a semiconductor containing amorphous tellurium oxide, thin film transistor including same and fabrication method therefor.

### Background Art

In the past few decades, metal oxide semiconductors have promoted great progress in modern optoelectronic research and have been widely used in transistors, photovoltaics, thermoelectrics, light-emitting diodes, displays, etc. However, commercially available oxide semiconductors with high electrical performance are all n-type semiconductors that are efficient only in electron transport at room temperature. There is no p-type semiconductor that can transport holes, which limits their application in various fields. Amorphous a-InGaZnO, a representative n-type semiconductor, has been commercialized as a backplane transistor that drives organic light-emitting diode (OLED) displays. The high dispersion conduction band minimum (CBM) enables excellent electron transport characteristics even in an amorphous structure, but there is a problem that p-type characteristics cannot be exhibited at room temperature.

Materials such as CuₓO and SnO have been studied as p-type metal oxide semiconductors that can transport holes even at room temperature. But compared to n-type metal oxides, they show poor electrical performances such as low hole field-effect mobility and low on/off current ratio, which significantly limits the development of pn junction diode-based optoelectronics and CMOS (Complementary Metal Oxide Semiconductor) circuits.

The main reason why metal oxide semiconductors have poor p-type characteristics is that the valence band maximum for hole transport in metal oxides is mainly anisotropic and is relatively small in size, so it consists of highly localized oxygen 2p orbitals. In addition, the metastable cation valence states of Cu⁺ and Sn²⁺ are unstable under an air condition, so their ambient stability is poor. In this regard, the development of stable, low-cost and high-mobility p-type semiconductors is very important in the current microelectronics industry.

### Disclosure

### Technical Problem

The present disclosure, which has been proposed to solve the problems described above, the purpose of the present disclosure is to solve the above problems and to propose a new amorphous p-type semiconductor of TeOₓ using a deposition technique such as thermal evaporation or sputtering and to provide a high-performance p-channel transistor using the same as a semiconductor layer.

In addition, another purpose of the present disclosure is to provide a high-performance p-channel TeOₓ thin film transistor having high stability and high performance at a low processing temperature.

In addition, another purpose of the present disclosure is to provide a large-area flexible thin film transistor using low cost.

### Technical Solution

One aspect of the present disclosure provides a semiconductor comprising: a chalcogen atom comprising at least one selected from the group consisting of a sulfur(S) atom and a selenium(Se) atom; and a tellurium composite comprising a tellurium (Te) atom and tellurium oxide.

In addition, the chalcogen atom may be doped in the tellurium composite.

In addition, the tellurium composite may be represented by chemical formula 1 below.

[Chemical formula 1] TeOₓ

In the chemical formula 1,
x is 0.8≤x≤1.7.

In addition, the tellurium oxide may comprise a tellurium monoxide (TeO) and a tellurium dioxide (TeO₂).

In addition, the semiconductor may be represented by chemical formula 2 below,

[Chemical Formula 2] TeOₓ:M

in the chemical formula 2,
M is sulfur(S) atom or selenium(Se) atom,
x is 0.8≤x≤1.7 and,
M is 0.5 to 5 atom % of the total number of Te atom, O atom and the M atom.

In addition, the semiconductor may be amorphous.

In addition, the tellurium semiconductor may be p-type.

In addition, the semiconductor may be in an oxygen-deficient state and the oxygen-deficient state may mean a state in which the ratio of oxygen in the stoichiometry ratio of tellurium(Te):oxygen(O) is less than 1:2.

In addition, the tellurium atom of the semiconductor may comprise an ionization state of Te⁴⁺, an ionization state of Te²⁺ and a non-ionization state of Te⁰, wherein the semiconductor may use a shallow acceptor state formed by a 5p-orbital of the Te²⁺ and Te⁰ as a hole conduction channel.

In addition, the selenium atom of the semiconductor may comprise an ionization state of Se²⁻. Here, the partially empty 4p state can be used as a hole conduction channel as the Se²⁻ of the semiconductor passivates the oxygen vacancy. At this time, the cation-anion bond of Te-Se is formed to maximize the overlap between the cation 5p orbital and the anion 4p orbital, so that the hole transfer can occur smoothly.

In addition, the semiconductor may be used in a semiconductor layer of a thin film transistor.

In addition, the thickness of the semiconductor layer may be 2 to 10 nm, preferably 3 to 9 nm, more preferably 4 to 8.5 nm and even more preferably 5 to 7 nm.

Another aspect of the present disclosure provides a thin film transistor comprising: a gate electrode; an insulating layer positioned on the gate electrode; a semiconductor layer positioned on the insulating layer and comprising a semiconductor according to the present disclosure; and a source electrode and a drain electrode positioned apart from each other on the semiconductor layer.

In addition, the gate electrode may comprise at least one selected from the group consisting of n-doped silicon (n-doped Si), p-doped silicon (p-doped Si), gold (Au), silver (Ag), platinum (Pt), titanium (Ti), aluminum (Al), tungsten (W), magnesium (Mg), calcium (Ca), ytterbium (Yb), chromium (Cr), nickel (Ni), molybdenum (Mo), gold oxide, platinum oxide, silver oxide, palladium oxide, iron oxide, graphene, carbon nanotube (CNT), silver nanowire (Ag nanowire, Ag NW), indium tin oxide and poly(3,4-ethylenedioxythiophene) polystyrene sulfonate (PEDOT:PSS).

In addition, the source electrode and the drain electrode may each comprise at least one selected from the group consisting of gold (Au), silver (Ag), platinum (Pt), titanium (Ti), aluminum (Al), tungsten (W), magnesium (Mg), calcium (Ca), ytterbium (Yb), chromium (Cr), nickel (Ni), molybdenum (Mo), gold oxide, platinum oxide, silver oxide, palladium oxide, iron oxide, graphene, carbon nanotube (CNT), silver nanowire (Ag NW), indium tin oxide and poly (3,4-ethylenedioxythiophene) polystyrene sulfonate (PEDOT:PSS).

In addition, the insulating layer may comprise at least one selected from the group consisting of silicon dioxide, glass, quartz, alumina, silicon carbide, magnesium oxide, polyethylene naphthalate (PEN), polyethylene terephthalate (PET), polystyrene (PS), polyimide (PI), polyvinyl chloride (PVC), polyvinyl pyrrolidone (PVP), polyethylene (PE), silicon oxide (SiO₂), germanium, polyvinyl alcohol (PVA), polymethyl methacrylate (PMMA), zirconium oxide (ZrO₂), aluminum oxide (AlO₂) and hafnium oxide (HfO₂).

Another aspect of the present disclosure provides a method of fabricating a semiconductor layer, the method comprising: (a) preparing a mixture by mixing a chalcogen comprising at least one selected from the group consisting of a sulfur(S) atom and a selenium(Se) atom and a tellurium dioxide (TeO₂); and (b) depositing the mixture to form a semiconductor layer comprising a semiconductor, wherein the semiconductor comprises a chalcogen atom comprising at least one selected from the group consisting of a sulfur(S) atom and a selenium(Se) atom; and a tellurium composite comprising a tellurium(Te) atom and a tellurium oxide.

In addition, the deposition of step (b) may be carried out by thermal deposition, sputtering, vapor phase chemical vapor deposition (CVD) or solution coating.

In addition, the deposition of step (b) may be carried out by thermal deposition or sputtering.

In addition, a temperature of the substrate deposited in the thermal deposition may be a range of 15 to 35 °C, preferably a room temperature.

In addition, a temperature of the substrate deposited in the sputtering may be a range of 15 to 35 °C, preferably a room temperature.

In addition, the thermal deposition or the sputtering may be carried out under a vacuum pressure of 10⁻³ Torr or less.

In addition, a thermal deposition rate of the semiconductor layer may be 1 to 100 Å/s when performing the thermal deposition,

In addition, the molar ratio of the chalcogen and the tellurium dioxide (TeO₂) of step (a) may be 0.01:99.99 to 50:50 (mol:mol).

In addition, a molar ratio of the tellurium and the oxygen of the semiconductor layer may be controlled by regulating a partial pressure of oxygen and argon plasma when performing the sputtering of step (b).

In addition, the method may comprise, after step (b), (c) annealing the semiconductor layer of step (b) at a temperature in a range of 100 to 300 °C in an air or an oxygen atmosphere.

In addition, the method may comprise, after step (c), (d) annealing at a temperature in a range of room temperature to 300 °C in air.

Another aspect of the present disclosure provides a method of fabricating a thin film transistor, the method comprising: (1) preparing a gate electrode/insulating layer laminate comprising a gate electrode and an insulating layer positioned on the gate electrode; (2) forming a semiconductor layer comprising a semiconductor on the insulating layer; and (3) forming a source electrode and a drain electrode on the semiconductor layer, wherein the semiconductor comprises, a chalcogen atom comprising at least one selected from the group consisting of a sulfur atoms (S) and a selenium atoms (Se); and a tellurium composite comprising a tellurium (Te) atoms and a tellurium oxide.

### Advantageous Effects

A thin film transistor (TFT) fabricated on the basis on the TeOₓ channel layer according to the present disclosure exhibits excellent output/transfer characteristics and superior electrical performance with high hole field-effect mobility and a high on/off current ratio of ~10⁷.

### Description of Drawings

Since the accompanying drawings are intended to illustrate exemplary embodiments of the present disclosure, the technical ideas of the present disclosure should not be construed to be limited by the accompanying drawings.
FIG. 1 shows a schematic diagram for a method of fabricating a semiconductor layer for use in a selenium-doped amorphous p-channel thin film transistor using a thermal evaporation process according to Example 1.
FIG. 2A shows a graph of the XRD (X-ray Diffractometer) spectrum results of a TeOₓ:Se thin film annealed at 225 °C and thermally evaporated according to Example 1-1.
FIGs. 2B and 2D show high-resolution transmission electron microscopy (HRTEM) image of an amorphous TeOₓ:Se thin film according to Example 1-1.
FIG. 2C shows an image of a selected area electron diffraction pattern of an amorphous TeOₓ:Se thin film according to Example 1-1.
FIG. 2E shows an image of a pattern of Fourier transform points of a TeOₓ:Se annealed at 225 °C according to Example 1-1.
FIG. 3 shows a graph of X-ray absorption near-edge structure (XANES) of a tellurium oxide doped with 2 atom % selenium (Se) according to Example 1-1.
FIG. 4 shows a graph of XPS (X-ray photoelectron spectroscopy) depth profile element distribution of a TeOₓ:Se thin film doped with 2 atom % selenium (Se) according to Example 1-1.
FIG. 5A shows a high-resolution transmission electron microscopy (HRTEM) image of a semiconductor layer based on an amorphous p-channel TeOₓ doped with selenium according to Example 1-1.
FIG. 5B shows a graph of XPS (X-ray Photoelectron Spectroscope) tellurium (Te) 3d spectra of the selenium (Se)-doped tellurium oxide of Examples 1-1 and 1-2 and a selenium (Se)-undoped tellurium oxide of Comparative Example 1-1.
FIG. 5C shows a graph of XPS (X-ray Photoelectron Spectroscope) oxygen (O) 2p spectra of selenium (Se)-doped tellurium oxide of Examples 1-1 and 1-2 and the selenium (Se)-undoped tellurium oxide of Comparative Example 1-1.
FIG. 6 shows a graph of transfer characteristics according to a selenium doping ratio of a Se-doped TeOₓ:Se thin film transistors (TFTs) according to Examples 1-1 and 1-2 and a Se-undoped TeOₓ thin film transistor (TFTs) according to Comparative Example 1-1.
FIG. 7A shows a graph of transfer curves (channel post-annealing temperature: 225 °C) of TeOₓ:Se thin film transistors (TFTs) manufactured with channel thicknesses of 2, 4, 6 and 8 nm using thermal deposition process according to Example 1-1.
FIG. 7B shows a graph of transfer curves of TeOₓ:Se thin film transistors (TFTs) manufactured with a channel thickness of 6 nm by depositing different channel layers at the post-annealing temperature using the thermal deposition process according to Example 1-1.
FIG. 8 shows a graph of the XPS (X-ray photoelectron spectroscopy) selenium (Se) 3p spectra of TeOₓ:Se doped with selenium (Se) under optimized conditions using a thermal deposition process according to Example 1-1 and a pristine TeOₓ sample undoped with selenium (Se) according to Comparative Example 1-1.
FIG. 9A shows a graph of the transfer curves of a thin film transistor (TFT) using a TeOₓ:Se channel that is not patterned differently using a thermal deposition process according to Example 1-1 and a thin film transistor (TFT) using a TeOₓ:Se channel patterned through photolithography according to Example 1-1.
FIG. 9B shows a schematic diagram of photolithography used for patterning TeOₓ:Se channels using a thermal deposition process according to Example 1-1.
FIG. 10A shows a graph of the transfer characteristics of TeOₓ and TeOₓ:Se TFTs using the thermal deposition process according to Example 1-1 and Comparative Example 1-1.
FIG. 10B shows a graph of the output curve of the TeOₓ:Se thin film transistor (TFT) using the thermal deposition process according to Example 1-1.
FIG. 10C shows a graph of the µh and Iₒₙ/I_{off} benchmarks of the reported amorphous p-channel thin film transistor (TFT) using the thermal deposition process according to Example 1-1.
FIGs. 10D and 10E show graphs of the transfer curve and VTH shift of the TeOₓ:Se thin film transistor (TFT) in PBS and NBS tests (±20 V) with different durations using the thermal deposition process according to Example 1-1.
FIG. 10F shows a graph of the transfer curve of a TeOₓ:Se thin film transistor (TFT) as a function of air exposure time (relative humidity: 10 to 30%) using thermal evaporation process according to Example 1-1.
FIG. 11A shows a graph of the transfer curve of 80 TeOₓ:Se thin film transistor (TFT) devices randomly measured when fabricating 80 TeOₓ:Se thin film transistor (TFT) devices on a 4-inch wafer through optimized conditions (VDS = -0.1 V) using a thermal evaporation process according to Example 1-1 and the inserted figure is an optical image of the thin film transistor (TFT) array on the 4-inch SiO₂ wafer.
FIG. 11B shows a graph of the extracted statistical results of the thin film transistor (TFT) field-effect hole mobility (µh) using the thermal evaporation process according to Example 1-1.
FIGs. 12A, 12B and 12C show a complementary inverter diagram, voltage transfer and noise margin (NM) extraction, and gain voltage curve based on n-channel In₂O₃ and p-channel TeOₓ:Se thin film transistors (TFTs) at VDD = 20 V using the thermal deposition process according to Example 1-1, respectively.
FIGs. 12D, 12E and 12F show photographs and input and output waveform graphs for complementary NAND and NOR logic gates at VDD = 12 V using a thermal deposition process according to Example 1-1, respectively.

### Best Mode

Herein after, embodiments of the present disclosure will be described in detail with reference to the accompanying drawings in such a manner that the ordinarily skilled in the art can easily implement the embodiments of the present disclosure.

But the description given below is not intended to limit the present disclosure to specific embodiments. In relation to describing the present disclosure, when the detailed description of the relevant known technology is determined to unnecessarily obscure the gist of the present disclosure, the detailed description may be omitted.

The terminology used herein is for the purpose of describing particular embodiments only and is not intended to limit the scope of the present disclosure. As used herein, the singular forms "a", "an" and "the" are intended to comprise the plural forms as well unless the context clearly indicates otherwise. It will be further understood that the terms "comprise" or "have" when used in the present disclosure specify the presence of stated features, integers, steps, operations, elements and/or combinations thereof, but do not preclude the presence or addition of one or more other features, integers, steps, operations, elements and/or combinations thereof.

Terms comprising ordinal numbers used in the specification, "first", "second", etc. can be used to discriminate one component from another component, but the order or priority of the components is not limited by the terms unless specifically stated. These terms are used only for the purpose of distinguishing a component from another component. For example, without departing from the scope of the present disclosure, a first component may be referred to as a second component and a second component may be also referred to as a first component.

In addition, when it is mentioned that a component is "formed", "stacked" or "laminated" on another component, it should be understood such that one component may be directly attached to or directly stacked on the front surface or one surface of the other component or an additional component may be disposed between them.

A semiconductor layer comprising an amorphous tellurium oxide, a thin film transistor and method of fabricating same will be described in detail. However, those are described as examples and the present disclosure is not limited thereto and is only defined by the scope of the appended claims.

The present disclosure provides a semiconductor comprising: a chalcogen atom comprising at least one selected from the group consisting of a sulfur(S) atom and a selenium(Se) atom; and a tellurium composite comprising a tellurium(Te) atom and a tellurium oxide.

In addition, the chalcogen atom may be doped in the tellurium composite.

In addition, the tellurium composite may be represented by chemical formula 1 below.

[Chemical formula 1] TeOₓ

in the chemical formula 1,
x is 0.8≤x≤1.7, preferably 1.0≤x≤1.5, more preferably 1.1≤x≤1.4. Here, when x is less than 0.8, a large number of Te-Te bonds are comprised, so that the charge amount increases, which is undesirable as a transistor semiconductor layer. When x is more than 1.7, the charge amount is too low, which is undesirable.

In addition, the tellurium oxide may comprise a tellurium monoxide (TeO) and a tellurium dioxide (TeO₂).

In addition, the semiconductor may be represented by chemical formula 2 below.

[Chemical formula 2] TeOₓ:M

in the chemical formula 2,
M is a sulfur(S) atom or a selenium(Se) atom, and
x is 0.8≤x≤1.7, preferably 1.0≤x≤1.5, more preferably 1.1≤x≤1.4. Here, when x is less than 0.8, a large number of Te-Te bonds are comprised, so that the charge amount increases, which is undesirable as a transistor semiconductor layer. When it exceeds 1.7, the charge amount is too low, which is undesirable.

M is 0.5 to 5 atom %, preferably 1 to 4.5 atom %, more preferably 1.5 to 4 atom % of the total number of Te atom, O atom and the M atom. Here, when M is less than 0.5 atom %, the hole mobility is low due to too low a doping amount, which is not desirable. When it exceeds 5 atom %, the current value is low, which is not desirable.

In addition, the semiconductor may be amorphous.

In addition, the tellurium semiconductor may be p-type.

In addition, the semiconductor may be in an oxygen-deficient state and the oxygen-deficient state means a state in which the ratio of oxygen in the stoichiometry ratio of tellurium (Te): oxygen (O) is less than 1:2.

In addition, the tellurium atom of the semiconductor may comprise an ionization state of Te⁴⁺, an ionization state of Te²⁺ and a non-ionization state of Te⁰ and wherein, the semiconductor may use a shallow acceptor state formed by the 5p-orbitals of Te²⁺ and Te⁰ as a hole conduction channel.

In addition, the selenium atom of the semiconductor may comprise an ionization state of Se²⁻. Here, the partially empty 4p state can be used as a hole conduction channel as the Se²⁻ of the semiconductor passivates the oxygen vacancy.

In addition, the semiconductor may be used in a semiconductor layer of a thin film transistor.

In addition, the thickness of the semiconductor layer may be 2 nm or more, preferably 2 to 100 nm. Here, when the thickness of the semiconductor layer is less than 2 nm, the charge amount is small and it is difficult to obtain sufficient thin film coverage, which is undesirable. When the thickness of the thin film is too thick, the charge amount is too high, which is undesirable as a semiconductor layer of a transistor.

Another aspect of the present disclosure provides a thin film transistor comprising: a gate electrode; an insulating layer positioned on the gate electrode; a semiconductor layer positioned on the insulating layer and comprising a semiconductor according to the present disclosure; and a source electrode and a drain electrode positioned apart from each other on the semiconductor layer.

In addition, the gate electrode may comprise at least one selected from the group consisting of n-doped silicon (n-doped Si), p-doped silicon (p-doped Si), gold (Au), silver (Ag), platinum (Pt), titanium (Ti), aluminum (Al), tungsten (W), magnesium (Mg), calcium (Ca), ytterbium (Yb), chromium (Cr), nickel (Ni), molybdenum (Mo), gold oxide, platinum oxide, silver oxide, palladium oxide, iron oxide, graphene, carbon nanotube (CNT), silver nanowire (Ag nanowire, Ag NW), indium tin oxide and poly(3,4-ethylenedioxythiophene) polystyrene sulfonate (PEDOT:PSS).

In addition, the source electrode and the drain electrode may each comprise at least one selected from the group consisting of gold (Au), silver (Ag), platinum (Pt), titanium (Ti), aluminum (Al), tungsten (W), magnesium (Mg), calcium (Ca), ytterbium (Yb), chromium (Cr), nickel (Ni), molybdenum (Mo), gold oxide, platinum oxide, silver oxide, palladium oxide, iron oxide, graphene, carbon nanotube (CNT), silver nanowires (Ag NW), indium tin oxide and poly (3,4-ethylenedioxythiophene) polystyrene sulfonate (PEDOT:PSS).

In addition, the insulating layer may comprise at least one selected from the group consisting of silicon dioxide, glass, quartz, alumina, silicon carbide, magnesium oxide, polyethylene naphthalate (PEN), polyethylene terephthalate (PET), polystyrene (PS), polyimide (PI), polyvinyl chloride (PVC), polyvinyl pyrrolidone (PVP), polyethylene (PE), silicon oxide (SiO₂), germanium, polyvinyl alcohol (PVA), polymethyl methacrylate (PMMA), zirconium oxide (ZrO₂), aluminum oxide (AlO₂) and hafnium oxide (HfO₂).

Another aspect of the present disclosure provides a method of fabricating a semiconductor layer, the method comprising: (a) preparing a mixture by mixing a chalcogen comprising at least one selected from the group consisting of a sulfur(S) atom and a selenium(Se) atom and a tellurium dioxide(TeO₂); and (b) depositing the mixture to form a semiconductor layer comprising a semiconductor, wherein the semiconductor comprises a chalcogen atom comprising at least one selected from the group consisting of a sulfur(S) atom and a selenium(Se) atom; and tellurium composite comprising a tellurium(Te) atom and a tellurium oxide.

In addition, the deposition of step (b) may be carried out by thermal deposition, sputtering, vapor phase chemical vapor deposition (CVD) or solution coating.

In addition, the deposition of step (b) may be carried out by thermal deposition or sputtering.

In addition, a temperature of the substrate deposited in the thermal deposition may be a range of 15 to 35 °C, preferably a room temperature.

In addition, a temperature of the substrate deposited in the sputtering may be a range of 15 to 35 °C, preferably a room temperature.

In addition, the thermal deposition or the sputtering may be carried out under a vacuum pressure of 10⁻³ Torr or less. Here, when it is carried out under a vacuum pressure exceeding 10⁻³ Torr, the thermal deposition or the sputtering is undesirable because it may contain impurities.

In addition, when performing the thermal deposition, the thermal deposition rate may be 1 to 100 Å/s based on the semiconductor layer. Here, when the thermal deposition rate is less than 1 Å/s, the process time for thin film deposition is too long, which is undesirable. When it exceeds 100 Å/s, the surface roughness of the thin film increases, which is undesirable.

In addition, a molar ratio of the chalcogen and the tellurium dioxide (TeO₂) in step (a) may be 0.01:99.99 to 50:50 (mol:mol), preferably 0.1:99.9 to 30:70. That is, the doping concentration is 0.01 mol to 50 mol, preferably 0.1 mol to 30 mol. The doping concentration is the ratio of the mole number of chalcogen (C) to the total mole number of chalcogen (C) and tellurium dioxide (T), (C/(C+T)x100, mol/mol %). Here, when the molar ratio is less than 0.01:99.99, the doping effect is not effective, which is undesirable. When it exceeds 50:50, phase separation may occur, which is undesirable.

In addition, the molar ratio of tellurium and oxygen in the semiconductor layer can be controlled by regulating the partial pressure of oxygen and argon plasma during the sputtering in step (b).

In addition, the method (c) may comprise, after step (b), (c) annealing the semiconductor layer of step (b) at a temperature in a range of 100 to 300 °C in an air or an oxygen atmosphere.

In addition, the method may comprise, after step (c), (d) annealing at a temperature in a range of room temperature to 300 °C in air.

Another aspect of the present disclosure provides a method of fabricating a thin film transistor, the method comprising: (1) preparing a gate electrode/insulating layer laminate comprising a gate electrode and an insulating layer positioned on the gate electrode; (2) forming a semiconductor layer comprising a semiconductor on the insulating layer; and (3) forming a source electrode and a drain electrode on the semiconductor layer, wherein the semiconductor comprises, a chalcogen atom comprising at least one selected from the group consisting of a sulfur atoms (S) and a selenium atoms (Se); and a tellurium composite comprising a tellurium (Te) atoms and a tellurium oxide.

### Mode for Disclosure

### [Examples]

Hereinafter, the examples of the present disclosure will be described. However, the examples are for illustrative purposes, and the scope of the present disclosure is not limited by the examples.

### Example 1: Fabrication of selenium doped amorphous p-channel thin film transistor

### Example 1-1: 2 atom % Se-doped tellurium oxide

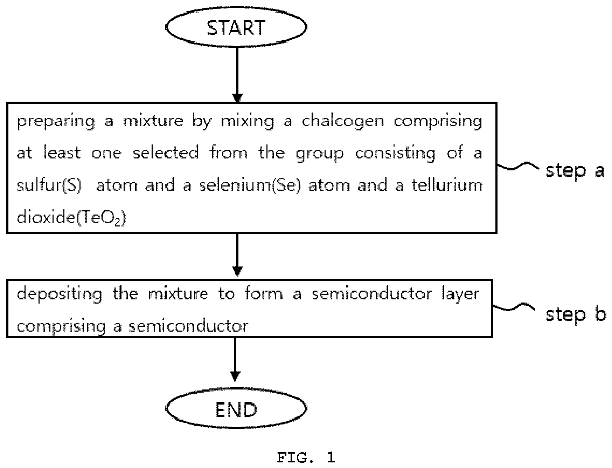

FIG. 1 shows a schematic diagram for a method of fabricating a semiconductor layer for use in a selenium-doped amorphous p-channel thin film transistor using a thermal evaporation process according to Example 1.

In order to deposit a tellurium oxide-based semiconductor film, commercially available TeO₂ powder (purity 97% or higher) was used as an evaporation source. Meanwhile, a small amount of chalcogen powder (S or Se) was mixed with TeO₂, and after deposition, the atomic ratio of tellurium oxide on the surface of the semiconductor layer was observed as Te:O:Se = 38:60:2 by XPS. However, the X-ray absorption results showed that the ratio of Te:O was 1:1.2, indicating that the amount of oxygen on the surface was greater. The TeOₓ-based film was deposited using a general thermal evaporator. The substrate temperature was 25 °C, and the vacuum pressure before evaporation was below 10⁻³ Torr. The distance between the substrate and the boat loaded with TeO₂ was 2 to 50 cm. The deposition rate was 1 Å/s. The thickness of the TeOₓ films (1 to 100 nm) was monitored during the deposition process. The deposited samples were first annealed at 200 °C for 30 min in a N₂-filled glove box, and then further annealed at 225 °C for 30 min in air. After that, the source/drain electrodes were deposited using Ni, respectively, to fabricate thin-film transistors (TFTs).

### Example 1-2: 4 atom % Se-doped tellurium oxide

A thin film transistor (TFT) was fabricated in the same manner as Example 1-1, with the exception that 4 atom % Se-doped tellurium oxide was deposited instead of that 2 atom % Se-doped tellurium oxide was deposited.

### Comparative Example 1: Se-undoped tellurium oxide

### Comparative Example 1-1: Pristine tellurium oxide

A thin film transistor (TFT) was fabricated in the same manner as Example 1-1, with the exception that Se-undoped tellurium oxide was deposited instead of that 2 atom % Se-doped tellurium oxide was deposited.

### [Test Example]

### Test Example 1: Amorphous and Crystalline Thin Film

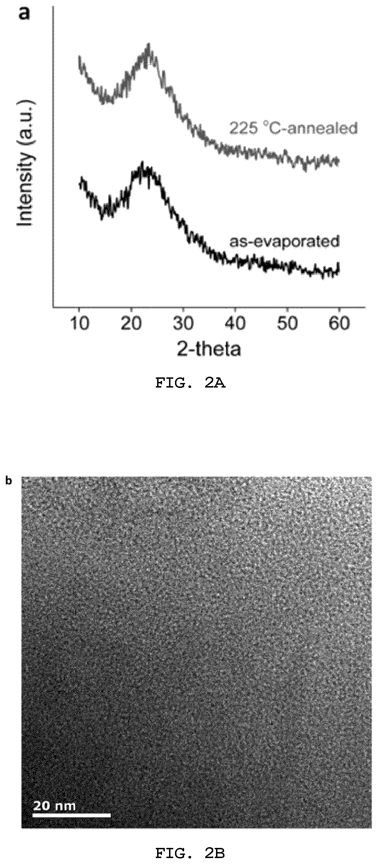

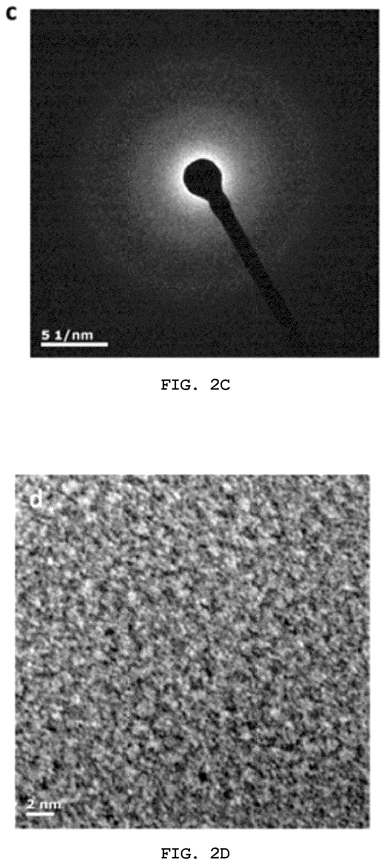

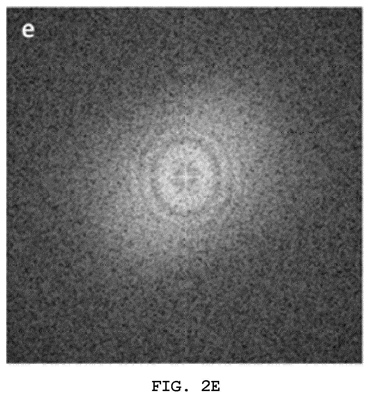

FIG. 2A is a graph showing the XRD (X-ray Diffractometer) spectrum results of a TeOₓ:Se thin film annealed at 225 °C and thermally evaporated according to Example 1-1, FIGs. 2B and 2D show high-resolution transmission electron microscopy (HRTEM) images of an amorphous TeOₓ:Se thin film of Example 1-1, FIG. 2C shows an image of a selected area electron diffraction pattern of an amorphous TeOₓ:Se thin film of Example 1-1 and FIG. 2E shows an image of a pattern of Fourier transform points of a TeOₓ:Se annealed at 225 °C according to Example 1-1. Referring to FIGs. 2A to 2E, it can be confirmed that the TeOₓ:Se thin film is amorphous.

### Test Example 2: XANES (X-ray absorption near-edge structure)

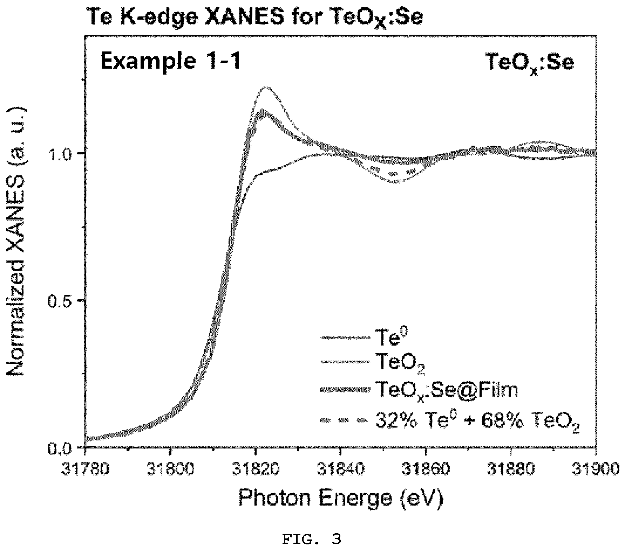

FIG. 3 shows a graph of a X-ray absorption near-edge structure (XANES) of a tellurium oxide doped with 2 atom % selenium (Se) according to Example 1-1. Referring to FIG. 3, it can be seen that the semiconductor layer contains tellurium(Te) atoms, tellurium oxide (TeOₓ), and tellurium dioxide (TeO₂), and it can be confirmed that the atomic composition of Te and O of the tellurium oxide doped with selenium (Se) according to Example 1-1 is TeO_{1.2}, and it can be seen that 2 atom % Se is doped therein.

### Test Example 3: XPS Depth Profile Element Distribution

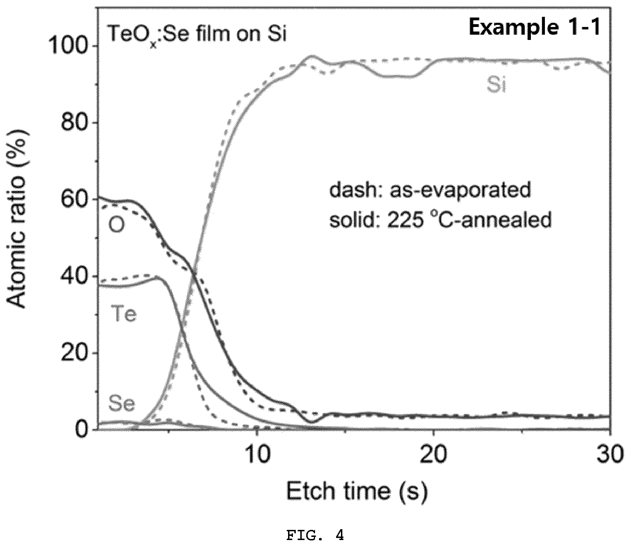

FIG. 4 shows a graph of the XPS (X-ray photoelectron spectroscopy) depth profile element distribution of the TeOₓ:Se thin film doped with 2 atom % selenium (Se) according to Example 1-1. Referring to FIG. 4, it can be confirmed that tellurium (Te), oxygen (O), selenium (Se), and silicon (Si) are distributed in a uniform composition in the thin film.

### Test Example 4: High-resolution TEM

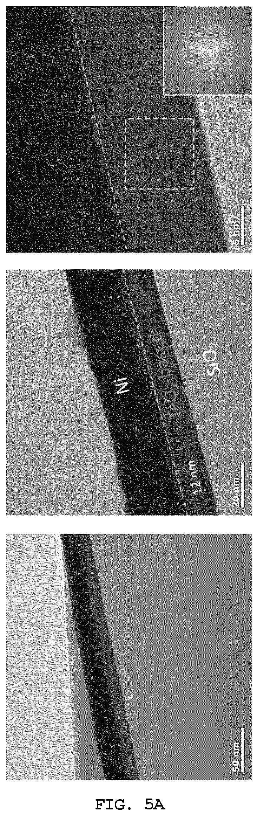

FIG. 5A shows a high-resolution transmission electron microscopy (HRTEM) image of a semiconductor layer based on an amorphous p-channel TeOₓ doped with selenium according to Example 1-1. Referring to FIG. 5A, the microstructure of the semiconductor film, which is the deposited TeOₓ:Se thin film, shows a typical amorphous pattern without crystal regions.

### Test Example 5: XPS Spectrum

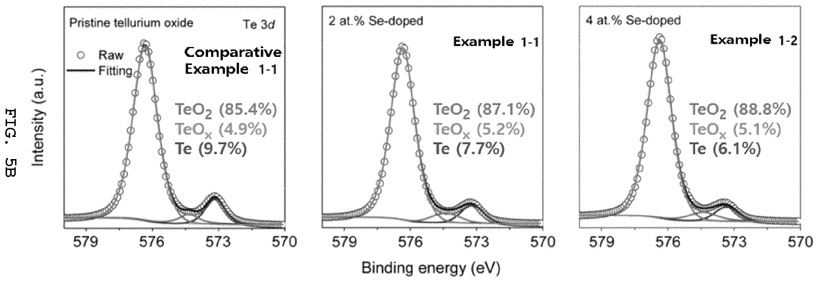

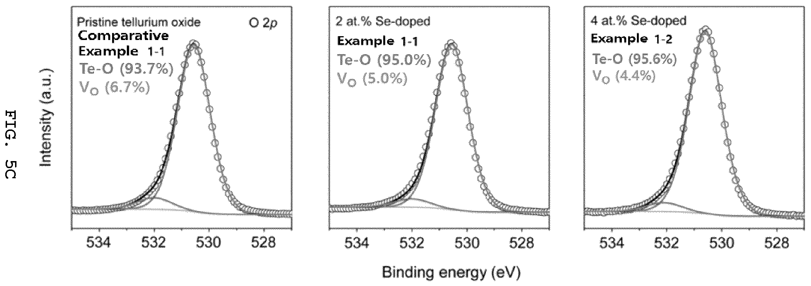

FIG. 5B shows a graph of the XPS (X-ray Photoelectron Spectroscope) tellurium (Te) 3d spectra of the selenium (Se)-doped tellurium oxide of Examples 1-1 and 1-2 and the selenium (Se)-undoped tellurium oxide of Comparative Example 1-1 and FIG. 5C shows a graph of the XPS (X-ray Photoelectron Spectroscope) oxygen (O) 2p spectra of selenium (Se)-doped tellurium oxide of Examples 1-1 and 1-2 and selenium (Se)-undoped tellurium oxide of Comparative Example 1-1. In FIG. 5B, x of TeOx (4.9%), TeOₓ (5.2%), and TeOₓ (5.1%) is 0<x<2.

Referring to FIGs. 5B and 5C, it can be seen that the semiconductor layer contains tellurium atoms (Te), tellurium oxide (TeOₓ), and tellurium dioxide (TeO₂). It can be seen that the atomic compositions of tellurium (Te) and oxygen (O) in the tellurium oxides according to Examples 1-1, 1-2, and Comparative Example 1-1 are TeO_{1.58}, respectively. In addition, the atomic ratios on the surfaces of the selenium (Se)-doped tellurium oxide thin films according to Examples 1-1 and 1-2 were analyzed to be Te:O:Se = 38:60:2 and 38:60:4, respectively. In addition, Example 1-1 can be expressed as TeO_{1.2}:Se_{0.052}, as in Test Example 2. Here, it can be seen that the oxygen composition according to the XPS result of Test Example 5 is greater than the oxygen composition according to the XANES result of Test Example 2. These results are judged to be because the surface of the sample is analyzed by XPS, while the bulk of the sample is analyzed by XANES, so the surface of the sample contains more oxygen than the bulk due to oxidation. However, it can be said that the bulk component has a greater effect on the device performance.

### Test Example 6: Transfer characteristics of TeOₓ:Se TFT

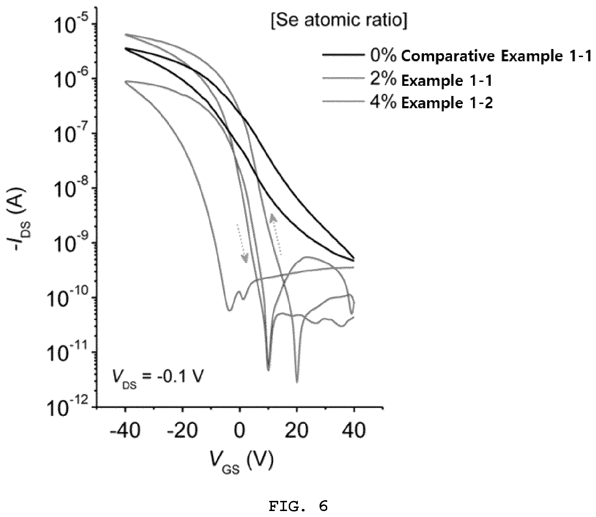

FIG. 6 shows a graph of transfer characteristics according to a selenium doping ratio of a Se-doped TeOₓ:Se thin film transistors (TFTs) according to Examples 1-1 and 1-2 and a Se-undoped TeOₓ thin film transistor (TFTs) according to Comparative Example 1-1.

Referring to FIG. 6, the highest hole mobility can be obtained when selenium (Se) is doped at 2 atom %, and it can be confirmed that the charge decreases at doping concentrations exceeding this.

### Test Example 7: Transfer Curve of TeOₓ:Se TFT

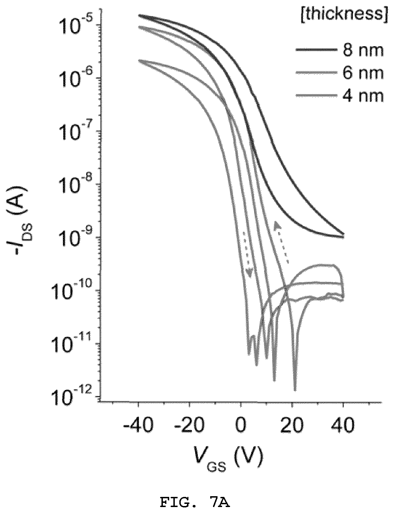

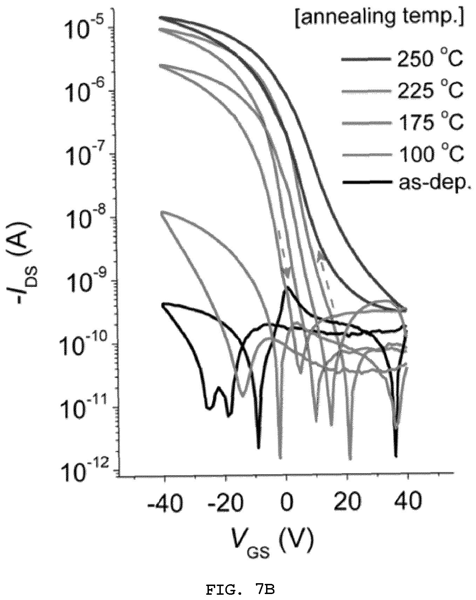

FIG. 7A shows a graph of transfer curves (channel post-annealing temperature: 225 °C) of TeOₓ:Se thin film transistors (TFTs) manufactured with channel thicknesses of 2, 4, 6 and 8 nm using thermal deposition process according to Example 1-1, and FIG. 7B shows a graph of transfer curves of TeOₓ:Se thin film transistors (TFTs) manufactured with a channel thickness of 6 nm by depositing different channel layers at the post-annealing temperature using the thermal deposition process according to Example 1-1.

Referring to FIGs. 7A and 7B, it can be confirmed that the charge increases as the thickness increases, and that the optimal process temperature is 225 °C.

### Test Example 8: XPS Se 3p Spectrum

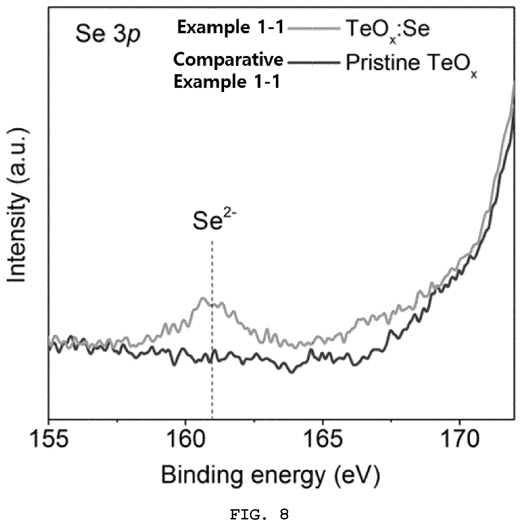

FIG. 8 shows a graph of the XPS (X-ray photoelectron spectroscopy) selenium (Se) 3p spectra of TeOₓ:Se doped with selenium (Se) under optimized conditions using a thermal deposition process according to Example 1-1 and a pristine TeOₓ sample undoped with selenium (Se) according to Comparative Example 1-1. Referring to FIG. 8, it can be confirmed that when selenium (Se) is doped, it exists as an anion phase of Se²⁻ in the TeOₓ thin film.

### Test Example 9: TFT using TeOx:Se channel

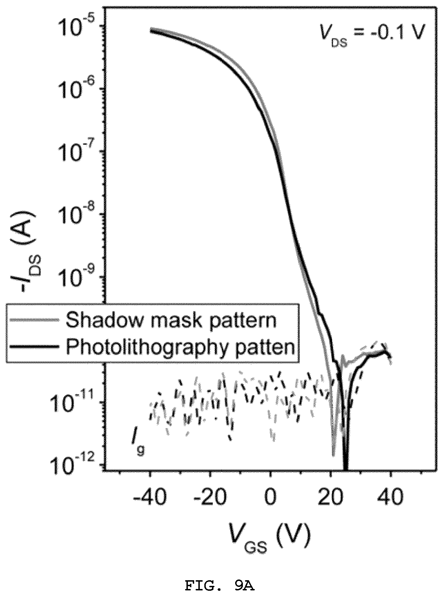

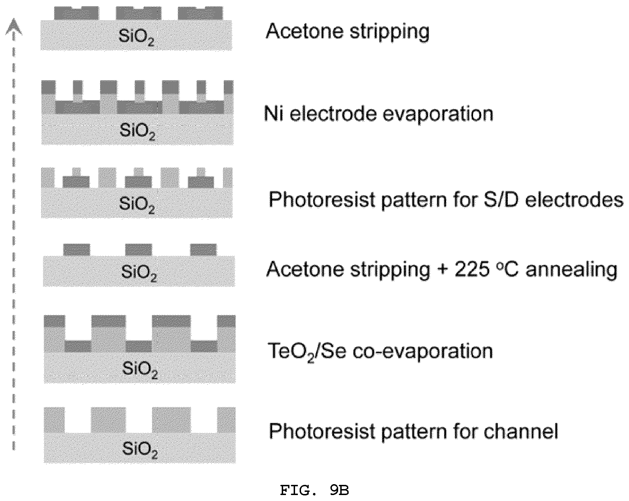

FIG. 9A shows a graph of the transfer curves of a thin film transistor (TFT) using a TeOₓ:Se channel that is not patterned differently using a thermal deposition process according to Example 1-1 and a thin film transistor (TFT) using a TeOₓ:Se channel patterned through photolithography according to Example 1-1. FIG. 9B shows a schematic diagram of photolithography used for patterning TeOₓ:Se channels using a thermal deposition process according to Example 1-1. Referring to FIG. 9A and 9B, it can be confirmed that there is no change in the performance of a thin film transistor (TFT) even after the patterning process using photolithography.

### Test Example 10: Electrical Characteristics of Amorphous P-Channel TeOₓ:Se TFTs

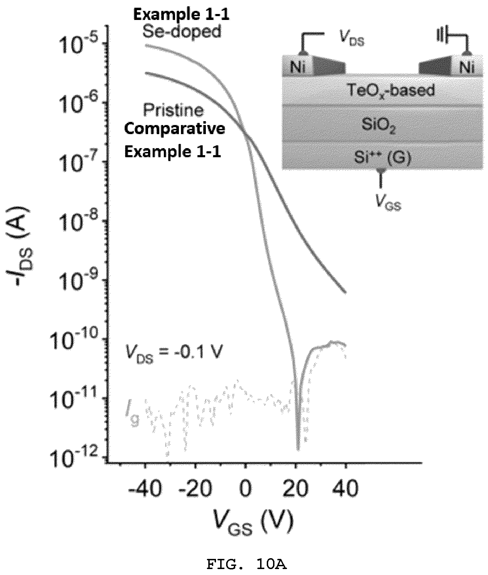

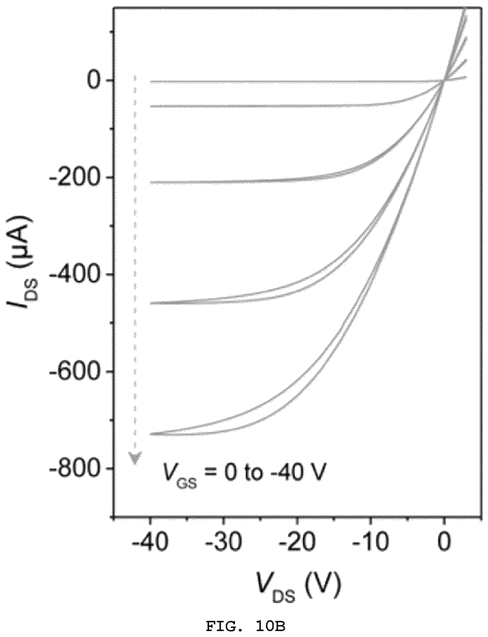

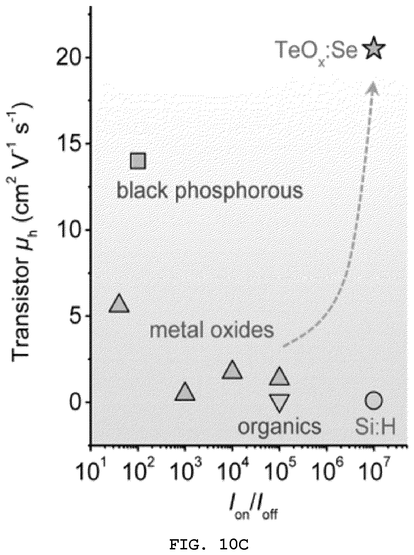

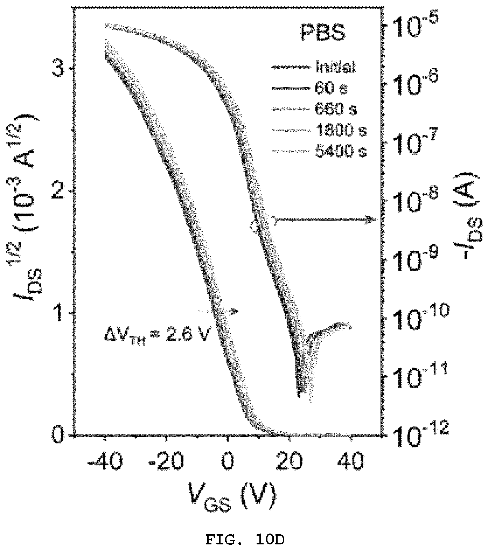

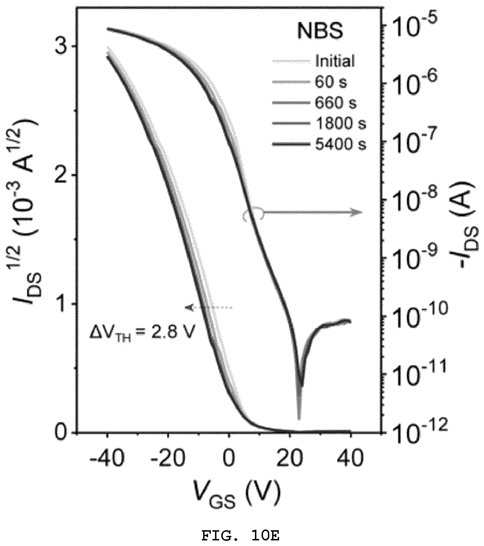

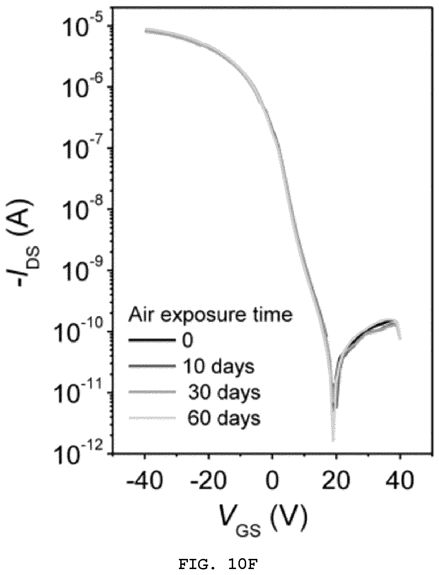

FIG. 10A shows a graph of the transfer characteristics of TeOₓ and TeOₓ:Se TFTs using the thermal deposition process according to Example 1-1 and Comparative Example 1-1, FIG. 10B shows a graph of the output curve of the TeOₓ:Se thin film transistor (TFT) using the thermal deposition process according to Example 1-1, FIG. 10C shows a graph of the µh and Iₒₙ/I_{off} benchmarks of the reported amorphous p-channel thin film transistor (TFT) using the thermal deposition process according to Example 1-1, FIGs. 10D and 10E show graphs of the transfer curve and VTH shift of the TeOₓ:Se thin film transistor (TFT) in PBS and NBS tests (±20 V) with different durations using the thermal deposition process according to Example 1-1 and FIG. 10F shows a graph of the transfer curve of a TeOₓ:Se thin film transistor (TFT) as a function of air exposure time (relative humidity: 10 to 30%) using thermal evaporation process according to Example 1-1. Referring to FIGs. 10A to 10F, the thin film transistor (TFT) geometry used in this disclosure can be confirmed.

### Test Example 11: TFT Field Effect Hole Mobility (µh)

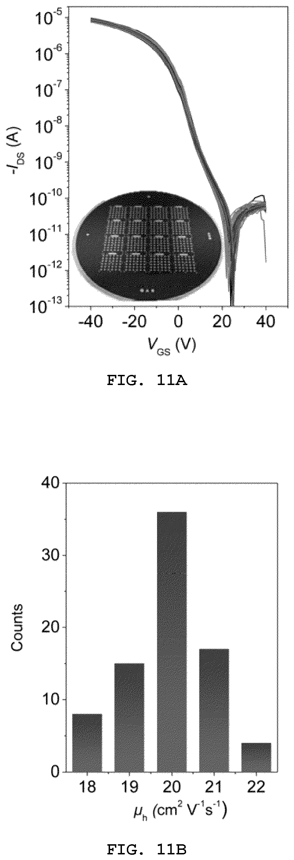

FIG. 11A shows a graph of the transfer curve of 80 TeOₓ:Se thin film transistor (TFT) devices randomly measured when fabricating 80 TeOₓ:Se thin film transistor (TFT) devices on a 4-inch wafer through optimized conditions (VDS = -0.1 V) using a thermal evaporation process according to Example 1-1 and the inserted figure is an optical image of the thin film transistor (TFT) array on the 4-inch SiO₂ wafer and FIG. 11B shows a graph of the extracted statistical results of the thin film transistor (TFT) field-effect hole mobility (µh) using the thermal evaporation process according to Example 1-1. Referring to FIGs. 11A and 11B, it can be seen that the average mobility is 20 cm²/VS and the on/off is 10⁷.

### Test Example 12: Integrated Circuit of TFT-Based Oxide

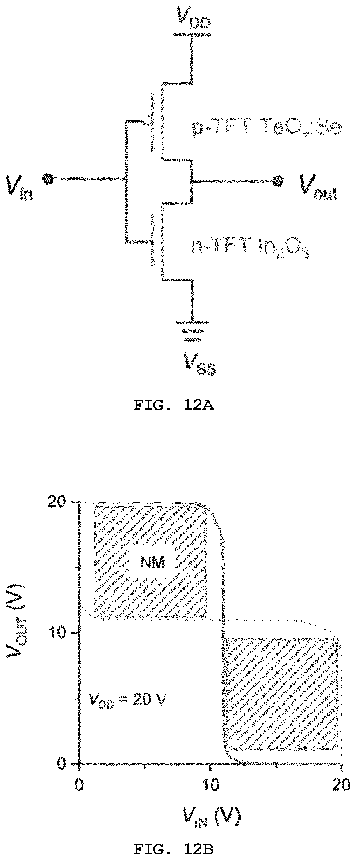

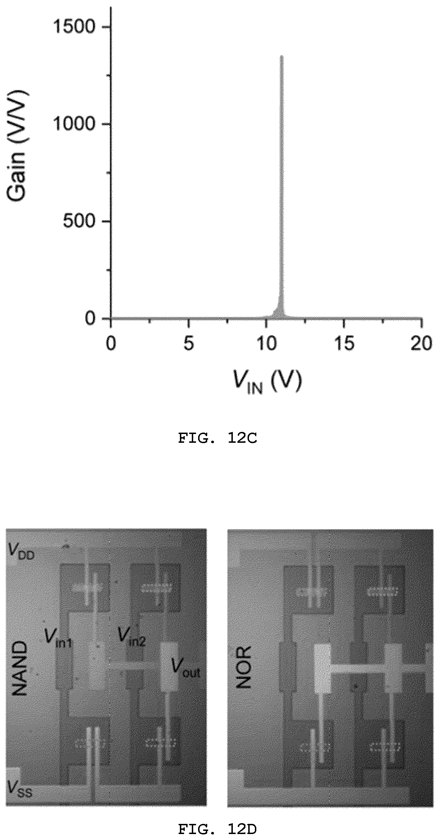

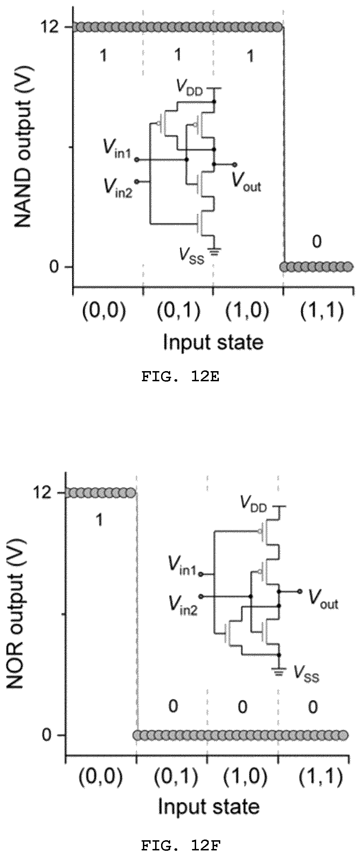

FIGs. 12A, 12B and 12C show a complementary inverter diagram, voltage transfer and noise margin (NM) extraction, and gain voltage curve based on n-channel In₂O₃ and p-channel TeOₓ:Se thin film transistors (TFTs) at VDD = 20 V using the thermal deposition process according to Example 1-1, respectively and FIGs. 12D, 12E and 12F show photographs and input and output waveform graphs for complementary NAND and NOR logic gates at VDD = 12 V using a thermal deposition process according to Example 1-1, respectively. Referring to FIGs. 12A to 12F, it can be confirmed that the device operates well without any change in device characteristics even when the TeOₓ:Se portion is successfully patterned through patterning using photolithography.

The scope of the present disclosure is defined by the following claims rather than the above detailed description, and all changes or modifications derived from the meaning and scope of the claims and their equivalent concepts should be interpreted as falling into the scope of the present disclosure.

## Claims

1. A semiconductor comprising:
a chalcogen atom comprising at least one selected from the group consisting of a sulfur(S) atom and a selenium(Se) atom; and
a tellurium composite comprising a tellurium(Te) atom and a tellurium oxide.

2. The semiconductor of claim 1, wherein the chalcogen atom is doped in the tellurium composite.

3. The semiconductor of claim 1, wherein the tellurium composite is represented by chemical formula 1 below,
[Chemical formula 1] TeOₓ
in the chemical formula 1,
x is 0.8≤x≤1.7.

4. The semiconductor of claim 3, wherein the tellurium oxide comprises a tellurium monoxide (TeO) and a tellurium dioxide (TeO₂).

5. The semiconductor of claim 1, the semiconductor is represented by chemical formula 2 below,
[Chemical Formula 2] TeOₓ:M
in the chemical formula 2,
M is sulfur(S) atom or selenium(Se) atom,
x is 0.8≤x≤1.7 and
M is 0.5 to 5 atom % of the total number of Te atom, O atom and the M atom.

6. The semiconductor of claim 1, wherein the semiconductor is amorphous.

7. The semiconductor of claim 1, wherein a tellurium semiconductor is p-type.

8. The semiconductor of claim 1, wherein the semiconductor is in an oxygen-deficient state.

9. The semiconductor of claim 8, wherein the tellurium atom of the semiconductor comprises an ionization state of Te⁴⁺, an ionization state of Te²⁺ and a non-ionization state of Te⁰.

10. The semiconductor of claim 1, wherein selenium atom of the semiconductor comprises an ionization state of Se²⁻.

11. The semiconductor of claim 1, wherein the semiconductor is used in a semiconductor layer of a thin film transistor.

12. The semiconductor of claim 11, wherein the thickness of the semiconductor layer is 2 to 10 nm.

13. A method of fabricating a semiconductor layer, the method comprising:
(a) preparing a mixture by mixing a chalcogen comprising at least one selected from the group consisting of a sulfur(S) atom and a selenium(Se) atom and a tellurium dioxide(TeO₂); and
(b) depositing the mixture to form a semiconductor layer comprising a semiconductor,
wherein the semiconductor comprises
a chalcogen atom comprising at least one selected from the group consisting of a sulfur(S) atom and a selenium(Se) atom; and
a tellurium composite comprising a tellurium(Te) atom and a tellurium oxide.

14. The method of claim 13, wherein the deposition of step (b) is carried out by thermal deposition, sputtering, vapor phase chemical vapor deposition (CVD) or solution coating.

15. The method of claim 14, wherein the deposition of step (b) is carried out by thermal deposition or sputtering.

16. The method of claim 15, wherein a thermal deposition rate of the semiconductor layer is 1 to 100 Å/s when performing the thermal deposition.

17. The method of claim 13, wherein the molar ratio of the chalcogen and the tellurium dioxide (TeO₂) of step (a) is 0.01:99.99 to 50:50 (mol:mol).

18. The method of claim 14, wherein a molar ratio of the tellurium and the oxygen of the semiconductor layer is controlled by regulating a partial pressure of oxygen and argon plasma when performing the sputtering of step (b).

19. The method of claim 13, further comprising, after step (b),
(c) annealing the semiconductor layer of step (b) at a temperature in a range of 100 to 300 °C in air or oxygen atmosphere.

20. A method of fabricating a thin film transistor, the method comprising:
(1) preparing a gate electrode/insulating layer laminate comprising a gate electrode and an insulating layer positioned on the gate electrode;
(2) forming a semiconductor layer comprising a semiconductor on the insulating layer; and
(3) forming a source electrode and a drain electrode on the semiconductor layer,
wherein the semiconductor comprises
a chalcogen atom comprising at least one selected from the group consisting of a sulfur(S) atom and a selenium(Se) atom; and
a tellurium composite comprising a tellurium(Te) atom and a tellurium oxide.
